# EUROPEAN PATENT SPECIFICATION

(11) **EP 2 756 319 B1**
(45) Date of publication and mention of the grant of the patent: **07.08.2019**
(21) Application number: 12773245.1
(22) Date of filing: 16.09.2012
(51) Int. Cl.: G01R 15/18

(54) **PRECISION NEAR-FIELD CURRENT TRANSDUCER**
PRÄZISIONSNAHFELDSTROMWANDLER
TRANSDUCTEUR DE COURANT EN CHAMP PROCHE DE PRÉCISION

(30) Priority: 16.09.2011 GB 201116091
(43) Date of publication of application: 23.07.2014
(73) Proprietor: Kelvatek Ltd., Knockmore Hill Industrial Park Lisburn, Co. Antrim BT28 2EX (GB)
(72) Inventor: BEASANT, Robert, Lisburn Antrim BT28 2EX (GB)
(74) Representative: FRKelly
(86) International application number: PCT/EP2012/068180
(87) International publication number: WO 2013/037986

(56) References cited:
- WO-A1-00/72027
- WO-A1-2005/119274
- DE-A1- 4 424 368
- JP-A- 11 295 348
- JP-A- 2007 309 732
- US-A- 3 626 291
- US-A- 4 897 600
- US-A- 5 012 218
- US-A1- 2005 253 573
- US-B1- 6 313 623

## Description

### Field of the Invention

The present invention relates to current transducers. The invention relates particularly to linear, non-magnetic current transducers. The invention further relates to electrical current and/or voltage measurement apparatus comprising a current transducer.

### Background to the Invention

When a time-varying electric current flows through a conductor a corresponding time-varying magnetic field exists in the space around it. Ampere's law states that the line integral of the magnetic flux density along any closed path equals the surface integral of the current density through the surface thus enclosed. Also, according to Faraday's law, a conductive loop in a changing magnetic field will have a voltage E generated across the ends of the loop proportional to the rate of change of the magnetic flux ϕ linking it.

The principles of these two laws can be applied to the measurement of alternating currents. One example of such a measuring device comprises a current transducer known as the 'Rogowski Coil', in which one or more coils each comprising turns of substantially uniform surface area are arranged to lie at substantially equal intervals on a line forming a closed loop which encircles the current to be measured. Each turn produces a voltage proportional to the rate of change of magnetic flux linking it, so that the time integral of the voltage from each turn approximates to the line integral, along one turn's pitch of the line of integration linking the centre of each turn, of the magnetic flux density. Hence the time integral of the sum of all the voltages generated in all the turns of the coils along the line of integration approximates to the current enclosed.

This approximation is adequate for many applications provided that the spatial gradient of the magnetic field is substantially constant where it links with the turns of the Rogowski coil. However, in close proximity to current-carrying conductors the spatial gradient of the magnetic field is very non-linear. Hence there will be a substantial difference between the flux density averaged over a given turn and the actual flux density at the point of intersection of the line of integration with the plane of the said turn. As a result, with the exception of substantially circular coils, the ability of Rogowski coils of any other shape to reject the magnetic field from the nearby external current is substantially compromised. This is exacerbated in situations where the amplitude of the nearby external current is substantially larger than the enclosed current to be measured.

By way of example United States patents US3626291, US4897600, US5012218, United States Patent Application US2005/253573, Japanese Patent Applications JP11295348, JP2007309732, International Patent Application WO2005/119274 and German Patent Application DE 4424368 disclose known current sensors.

It would be desirable to provide an improved current transducer.

### Summary of the Invention

A first aspect of the invention provides a current transducer as claimed in claim 1. The current transducer comprises at least one conductive coil shaped to define a plurality of turns and shaped to form a loop, wherein for each turn there is a substantially constant ratio between respective portions, ideally incrementally small portions, of the area defined by the respective turn, and the respective effective turns' pitch at the corresponding point of a line of integration normal to the respective turn. In preferred embodiments, the arrangement is such that the effective turn's density is substantially constant along said at least one coil (in particular around said loop).

Preferred embodiments of the invention are designed to aim to achieve an ideal implementation of Ampere's law throughout the whole volume of the transducer, rather than only along one line of integration.

The current transducer may comprise at least one conductive coil shaped to define a plurality of turns, said at least one coil being shaped to define a loop, said loop having at least one corner section (typically between two substantially straight sections), wherein said at least one corner section comprises a plurality of non-parallel turns, and wherein said at least one corner section comprises at least one (notional) band running parallel with a notional line around said loop and substantially normal to each of the respective turns that it intersects, and wherein advantageously in respect of the, or each, of said at least one band, the average pitch between successive turns is substantially constant, where said average pitch is an average of the respective pitches between successive (adjacent) turns across the entire width of the respective band. Alternatively, or in addition, said average pitch is substantially equal to the pitch between successive (adjacent) turns of the or each substantially straight section adjacent the corner section.

In typical embodiments, there is a plurality of said bands. It is also typical that the loop defined by said at least one conductive coil comprises a plurality of substantially straight sides (usually four or more but possibly two or three), a respective of said corner sections being located at each intersection between said substantially straight sides. Advantageously, the arrangement is such that the pitch between successive (adjacent) turns in each of said substantially straight sections and said average pitch in band of each corner section are substantially equal.

In some embodiments, at least one corner section may be angled, i.e. not curved. For example such corner sections may be formed by two substantially straight sections intersecting substantially perpendicularly or at an obtuse or an acute angle. In such cases, it is preferred that the corner section comprises a respective set of turns extending between a respective one of said substantially straight sections and the apex of the corner section, wherein the respective turns of each set are preferably substantially parallel with one another, and the respective width of (and therefore area defined by) successive adjacent turns of each set decreases in a direction from said respective straight section towards said apex. Preferably, each set comprises the same number of turns. Preferably, said width decreases at a substantially constant rate. Preferably the pitch between adjacent turns of each set is substantially constant (and preferably still is substantially the same as the pitch between adjacent turns of the respective straight section). Moreover, it is preferred that the respective pitch between adjacent turns of one set is substantially the same as the respective pitch between adjacent turns of the other set, and said respective turn widths preferably also decrease at substantially the same rate.

In one embodiment, said sets are arranged substantially symmetrically about a notional axis that bisects said corner section and extends radially of said loop. Preferably, however, said sets are offset with respect to one another along said notional radial axis. More preferably, said offset is substantially equal to 50% of the pitch between adjacent turns of said sets.

Advantageously, applying the banding technique described herein to straight coils allows near ideal corners to be created, of any angle, and hence complete coils capable of enclosing a conductor. Further advantageously, by offsetting the relative position of turn ends at a corner by (up to) half a turns' pitch, errors in straight-coil corners can be further reduced by a factor of (up to) four.

In alternative embodiments, at least one corner section may be curved. In such embodiments, the curved corner section preferably comprises at least two bands running parallel with a notional line around said loop and substantially normal to each of the respective turns that it intersects, said bands being mutually spaced-apart in a radial direction (i.e. in a direction substantially perpendicular with said notional line), and wherein each band comprises a respective set of non-parallel turns, each set extending at least partly but preferably fully around said corner section (typically between two straight sections, one at each end of the corner section.) Preferably, the angular pitch between adjacent turns of each set is substantially constant. The respective angular pitch of respective sets is advantageously different, whereby the respective angular pitch for said sets of turns decreases for bands that are further away from the centre of the loop, i.e. angular pitch decreases from band to band in a direction away from the centre of the loop. As a result, each set typically comprises a different number of turns, the number of turns increasing from band to band in a direction away from the centre of the loop. The preferred arrangement is such that for all bands, the notional effective average pitch (spacing rather than angle) between successive turns is substantially constant, where said effective average pitch is an average of the respective pitches between adjacent turns across the entire width of the respective band. Alternatively, or in addition, said average pitch is substantially equal to the pitch between adjacent turns of the or each substantially straight section adjacent the corner section.

The width of at least some of the turns in the curved corner section may be smaller than the width of the turns in the adjacent straight section(s). It is preferred that the width of the turns of the same band is substantially constant. However, the respective widths of the turns need not be the same for each band; the turns width may the same for some bands but not for others.

In some cases, one or more respective turns of two or more bands may be aligned or substantially aligned, in which case the aligned turns may be implemented as a single turn extending across said two or more bands.

Advantageously, respective ends of respective turns from respective bands that are located adjacent a boundary between said respective bands may be electrically connected together. Typically, an end of a turn from one band is electrically connected to an adjacent end of a turn from another band by an electrically conductive link. The link is preferably substantially aligned with (i.e. substantially coincident with or substantially parallel with) the boundary between the bands, which is preferably substantially perpendicular to the respective turns. Preferably, said links are provided in opposing pairs of linked turns, whereby said opposing pairs are substantially symmetrical about an intermediate radial axis.

In preferred embodiments, there is a simple, i.e. whole number, ratio between the number of turns in one band and the number of turns in an adjacent band including, for example, 1:2, 2:3, 3:4, 4:5 or 5:6. Where there are more than two bands, the ratio may differ between adjacent bands.

Advantageously, applying the banding technique described herein to combinations of straight and curved sections allows coils of any shape to be created with excellent position independence for the internal conductor and excellent rejection of fields from external conductors, even when in extremely close proximity to the coil.

A curved section can be divided up into any number of conceptual bands, depending on the width and other practical design considerations. The number and width of bands can be adjusted to give substantially complete rejection of fields from multiple external conductors of known fixed position relative to the coil. The number and width of bands can alternatively be adjusted to give substantially optimal rejection of fields from multiple external conductors of unknown or varying position relative to the coil. The ratio of turns in two adjacent bands along a given arc can be set to any rational fraction such as 1 :2, 2:3, 3:4 etc. At intersections between adjacent bands an inner turn that is not co-radial with either of the two nearest outer turns can be joined to one of them via a short, preferably circumferential, connection. Where there is a choice of direction for this short connection, pairs of adjacent connections can be deliberately made in opposite directions so that their small error voltages almost totally cancel each other out. Where there is no such nearby connection with which to cancel, a similar connection in another coil aligned with this coil can be used for mutual cancellation instead.

A further aspect of the invention provides an electrical current and/or voltage measuring device comprising a current transducer according to any other aspect of the invention.

Preferred embodiments of the invention exhibit substantially better immunity from the magnetic fields of nearby external currents. Rather than being an incremental improvement on existing Rogowski coil design, the fundamental basis of which is the application of Ampere's law along one line of integration for any given coil, preferred embodiments of the invention are based on the application of the principles of Ampere's law throughout the whole volume of the current transducer by dividing it up into notional bands and optimising the approximation to Ampere's law in each band separately.

Further advantageous aspects of the invention will be apparent to those ordinarily skilled in the art upon review of the following description of specific embodiments and with reference to the accompanying drawings.

### Brief Description of the Drawings

Embodiments of the invention are now described by way of example and with reference to the accompanying drawings in which:
Figure 1 is a schematic view of a current transducer being a first embodiment of the invention;
Figure 2 is a schematic view of a current transducer being a second embodiment of the invention;
Figure 3 is a schematic view of a current transducer being a third embodiment of the invention; and
Figure 4 is a schematic view of a current transducer being a fourth embodiment of the invention.

### Detailed Description of the Drawings

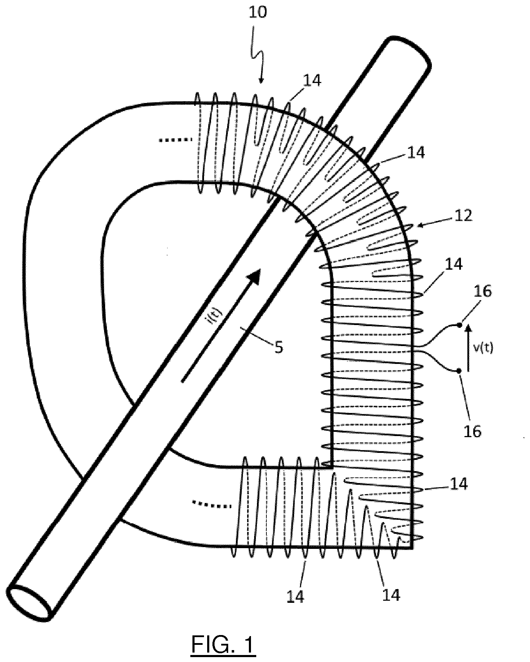

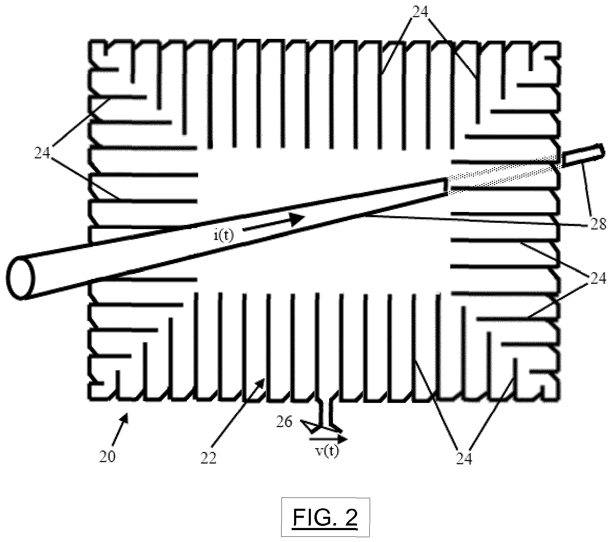

Referring first to Figures 1 and 2, there is shown, generally indicated as 10 and 20 respectively, respective current transducers embodying the invention. The transducer 10, 20 comprises at least one conductive coil 12, 22 shaped to define a plurality of turns 14, 24. In typical embodiments, said at least one conductive coil 12, 22 is shaped to define a loop that, in use, encircles a current or charge carrier 5, 28, e.g. a conductor, for carrying current that is desired to be measured. Alternatively the loop may encircle any other current or electrical charge carrier, e.g. a beam, for example, an ion beam. Usually, the arrangement is such that said loop is disposed in a plane which, in use, is substantially perpendicular to the current carrier 5, 28. It is noted however that the current carrier 5, 28 need not necessarily be perpendicular to the plane of the loop and that the loop itself need not necessarily be shaped to lie in a single plane. The turns 14, 24 of the at least one coil 12, 22 are usually disposed substantially transversely with respect to the loop. In typical embodiments where the loop is substantially planar, the turns 14, 24 are typically disposed in a respective plane that is substantially perpendicular to the plane in which said at least one coil lies.

Typically, said turns 14, 24 are electrically connected together in series. This interconnection of turns can be achieved in a variety of ways including, but not limited to, progressive connection of successive turns in a single direction around said loop.

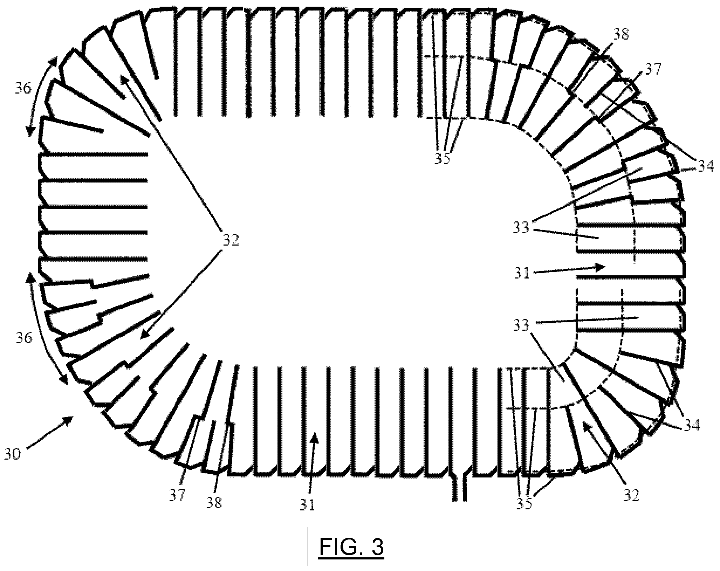

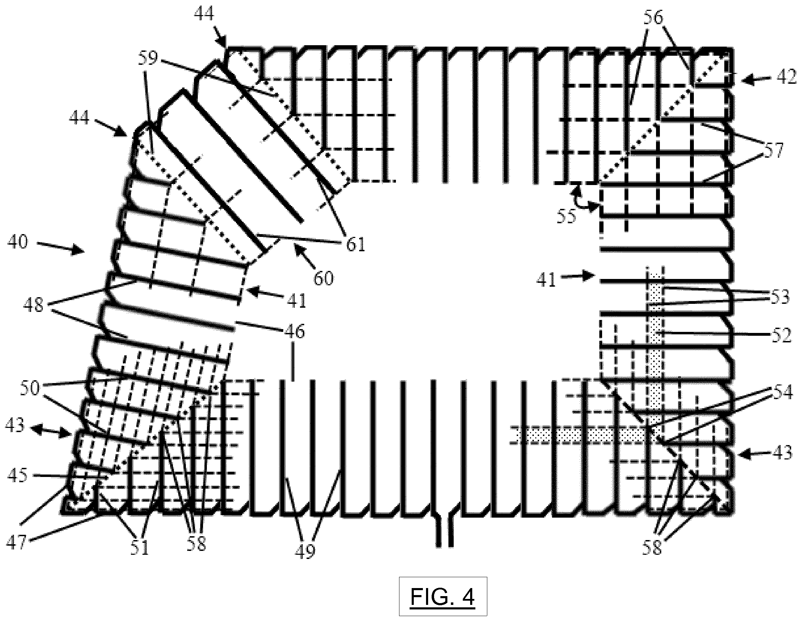

The turns 14, 24 may be shaped to define any shape, e.g. substantially circular, substantially rectangular or straight-sided with one or more curved corners, especially substantially rectangular with one or more curved corners. Said loop defined by said at least one coil 12, 22 may take any shape, e.g. substantially circular or substantially rectangular, but need not necessarily be planar. Various embodiments may have loops that are straight-sided with one or more curved corners, especially substantially rectangular with one or more curved corners, as illustrated in Figure 3, or with straight-sided, or 'mitred' corners (e.g. polygonal or quadrilateral), Figure 4.

Typically, the turns 14, 24 of any straight section of the coil 12, 22 are disposed relative to each of the turns immediately adjacent to it so as to provide a substantially constant ratio between the area of said turn and the space ('pitch') between said turn and said immediately adjacent turns.

Typically, but not necessarily, the pitch on straight sections of the coil 12, 22 are substantially constant and the surface area of the turns on the straight section of the coil are substantially constant.

The loop defined by the coil 12,22 may itself be considered as a turn (sometimes referred to as a "net turn") and, as such, may affect any current measurement made using the coil 12, 22. Accordingly, in typical embodiments, the transducer 10, 20 includes a further turn arranged to cancel the effect of the "net turn". This may be achieved for example by including an additional length of conductor (not shown), in series with the coil 12, 22 (e.g. at the beginning or the end of the at least one coil 12, 22), but extending around said current carrier 5, 28 (in use) in a direction opposite to the direction of the "net turn" (i.e. such that current is directed in use around said additional length of conductor in an opposite sense to the overall or net current flow around said loop), and preferably being shaped, dimensioned and positioned to define an area that substantially matches the area defined by said loop. Alternatively, the transducer may include a further at least one coil (not shown), in series with the coil 12,22 (e.g. at the beginning or the end of the coil 12, 22), and defining a loop that extends around said current carrier 5, 28 (in use) in a direction opposite to the direction of the "net turn" (i.e. such that overall or net current flow around said further at least one coil is in an opposite sense to the overall or net current flow around the loop defined by the coil 12, 22), and preferably being shaped, dimensioned and positioned to define an area that substantially matches the area defined by said net turn of said loop defined by the coil 12, 22

The transducer 10, 20 includes at least two terminals 16,26 across which the voltage induced in the at least one coil 12, 22 (and any additional conductors that may be connected to the at least one coil 12, 22, e.g. the additional length of conductor or the further at least one coil), in use, by current flowing in the current carrier 5, 28 can be measured. Typically, said voltage is an aggregate of the respective voltages induced in each turn of the transducer 10, 20 (including the turns 14, 24 and any turn(s) defined by said additional length of conductor or said further at least one coil).

The terminals 16, 26 are typically connected to electrical current and/or voltage measurement circuitry (not shown). As such, the transducer 10, 20 forms part of an electrical current and/or voltage measurement apparatus.

Referring now in particular to the transducer 30 of Figure 3, the coil may have at least two sections of differing radii, including but not limited to at least one straight section (or a curved section of substantially infinite radius) 31 and at least one curved corner 32, in which it is consequently not possible to maintain a substantially constant pitch at all radii of the corner. Advantageously, curved corners 32 of the coil are subdivided into notional bands 33, preferably by the inclusion of additional turns 34 of less than full width, such that the ratio of the transverse area of the intersection between a given turn 34 and the or each respective band 33 to its respective notional effective, or average, pitch averaged across the width of the respective band at the intersection is substantially equal to the corresponding area to pitch ratio on a straight section 31 of the band 33. Effective turns' pitch may be calculated as an average pitch (distance) between a turn and an adjacent turn. For example, two adjacent turns at a corner of a coil are non-parallel as a result of the angular pitch between them. Consequently, the pitch between the turns changes, i.e. increases in an outward direction. In this context the pitch is a distance rather than an angle. Where the corner is curved, the pitch may be measured as an arc between the adjacent turns, the curvature of the arc matching the curvature of the corner. Where the corner is straight-edged, the pitch may be measured along straight lines parallel with the corner axes.

The number of bands 33 in any curved corner 32 can vary according to the requirements pertaining to the corner. The positions of the notional boundaries 35 defining the position and width of any of said at least one bands can vary according to the requirements pertaining to the curved corner.

Curved corners of the coil can comprise one or more repeating angular patterns of turns 36. Within the patterns of turns each band has a given integer number of turns. The greater the radius of the band 33 within the pattern region 36 the greater will be the number of turns in the band 33. There are a variety of possible ratios of turns from one band to an adjacent band of greater radius, including, but not limited to, 1:2, 2:3, 3:4, 4:5, etc. In some embodiments where the turns pass from one band to an adjacent band, the route of the turn may follow the band boundary for a distance which is substantially small relative to the width of the bands, thereby creating an interconnection 37 between notional subdivisions of the turn. In some embodiments each interconnection 37 has, advantageously, a corresponding mirror image interconnection 38 substantially nearby on the same boundary, such that any magnetic field coupling with the one interconnection 37 will also couple with the other interconnect 38 in substantially the opposite way, thus substantially cancelling unwanted error signals.

In any embodiment, having a given ratio between the turns' area and turns' pitch (i.e. 'turns' density'), with at least one curved corner linking a first straight section of the coil of a given first width and first turns' pitch giving a ratio substantially equal to the turns' density of the at least one coil, to a second straight section of the coil of a given second width and second turns' pitch giving a ratio substantially equal to the turns' density of the coil, the inner and outer radius of the curved corner, the number and widths of the bands together with the angular pitches of the turns of the bands of the curved corner can be optimised to minimise the deviation of the local effective turns' density at all points of the curved corner from the turns' density, hence minimising the errors due to magnetic fields generated by any external currents and minimising errors due to any dependence on the position of the currents passing through the coil.

Referring now in particular to the current transducer of Figure 4, the coil 40 has at least two straight sections 41 meeting in a straight-sided or 'mitred' corner 42, 43, 44. A notional diagonal straight line 45 can be drawn from the intersection of the inner edges 46 of the two straight sections to the intersection of the corresponding outer edges 47 of the two straight sections and this notional straight line marks the transition from the turns 48 of one of the two straight sections to the turns 49 of the other straight section of the coil 40. In embodiments where the width of the two straight sections meeting in the corner are substantially equal 42, 43, it can be seen that the notional diagonal line 45 bisects the angle at which the two straight sections meet.

The turns 50 of one of the two straight sections continue into the corner, maintaining substantially the same pitch between adjacent turns, remaining substantially parallel to the turns 48 of the straight section and substantially uniformly reducing in width as they extend from the continued outer edge 47 of the straight section to the notional diagonal line 45 marking the transition of the corner. In typical embodiments the turns 51 of the other straight section also continue into the corner in substantially the same manner.

The two straight sections 41 and the straight or mitred corner 42,43,44 can be divided up into one or more notional bands 52, the bands filling the transverse area of the sections of the loop defined by the coil 40, without leaving voids between them and without overlapping each other, the inner and outer edges 53 of the bands being parallel to the edges 46, 47 of the straight sections 41, the notional line 53 marking each transition from one of the bands 52 to the adjacent band intersecting the notional diagonal line 45 of the corner 42,43,44 substantially at the point of intersection 54 of one of the corner turns 50,51 with the diagonal line 45.

The width of the notional bands 52 is substantially and advantageously of the same order as the pitch of the turns 50,51 forming the corner intersection 42,43,44 between the two straight sections 41 of the coil 40, such that the change in magnetic field strength, or change in gradient of magnetic field strength, between the corner intersections 54 of the band 52, resulting from a current flowing substantially near to the said corner of the band, combined with the change in pitch from the inner to the outer edge of the corner intersection of said band 54, will cause an error which is substantially negligible with respect to the total signal generated by the coil 40.

In some embodiments the notional diagonal line 45 marking the transition of the said corner 42 marks a line of substantial reflective symmetry 55 between the continuing turns 56 of one straight section and the corresponding turns 57 of the other straight section continuing into the said corner 42.

The intersection of two straight sections 41 of the coil 40 at a straight-sided or mitred corner 43, having the notional diagonal line 45 marking the transition from one straight section to the other straight section, may be configured such that turns 49,51 of one of the two straight sections is shifted along the straight section (offset) by substantially one half turns' pitch, such that the edges 58 of the corner turns of both straight sections lying on the notional diagonal line 45 of the corner 43 lie at substantially equal spacing along the notional diagonal line 45 such that the width of the notional bands 52 into which the corner 43 is divided is substantially constant. Furthermore, comparing the corner 43 with the corner 42, the number of notional bands has been doubled, and their width halved, giving up to a further factor of 4 improvement in the rejection of magnetic fields of external conductors.

The intersection of two straight sections of the coil 40 at a straight-sided or mitred corner 44, having the notional line 59 marking the transition from a first straight section 41 of a first width to the other straight section 60 of a second width, may be configured such that the width of the second straight section 60 is (substantially) greater than the width of the first straight section 41, and that the transition line 59 lies substantially parallel to the turns 61 of the second straight section 60 and is substantially perpendicular to the direction of the second straight section 60 of the coil 40, whereas the transition line 59 crosses the first straight section 41 at an angle oblique to the said turns 46 of the first straight section. The turns of the second straight section 60 continue up to the transition line 59 substantially uniformly, whereas the turns 50 of the first straight section continue into the corner 44, maintaining substantially the same pitch between adjacent turns, remaining substantially parallel to the turns 48 of the first straight section 41 and substantially uniformly reducing in width as they extend from the continued outer edge 47 of the first straight section 41 to the notional diagonal line 59 marking the said transition of the corner 44.

It will be understood that the various features described above in relation to any one of the transducers 10, 20, 30, 40 may be provided in any other of the transducers as would be apparent to a skilled person.

## Claims

1. A current transducer (10, 20, 30) comprising at least one conductive coil (12, 22, 40) shaped to define a plurality of turns (14, 24, 36, 48, 49, 50, 51) and shaped to form a loop, said loop having at least one corner section (32, 42, 43, 44) comprising a plurality of non-parallel turns, **characterised in that** for each turn there is a substantially constant ratio between respective portions of the area defined by the respective turn and a respective effective turns pitch at a corresponding point of a respective line of integration normal to the respective portion of said turn, wherein said at least one corner section comprises at least one notional band (33, 52) running parallel with a respective notional line (35, 53) around said loop and substantially normal to each of the respective portions of said turns that it intersects, and wherein said turns are shaped and dimensioned such that the ratio of the transverse area of the intersection between a respective turn and said at least one notional band to a respective effective pitch between said turn and an adjacent turn taken as an average across the width of said notional band at said intersection is substantially constant.

2. A current transducer as claimed in claim 1, wherein in respect of the, or each, of said at least one notional band (33, 52), the average pitch between successive turns (14, 24, 36, 48, 49, 50, 51) is substantially constant, where said average pitch is an average of the respective pitches between successive adjacent turns across the entire width of the respective notional band.

3. A current transducer as claimed in any preceding claim, wherein said at least one corner section (32, 42, 43, 44) includes a first set of turns (48, 49 having a full width and at least one other set of turns (34, 51) having a width less than said full width, and wherein preferably respective sets of turns are interleaved along the length of said at least one corner section.

4. A current transducer as claimed in claim 3, wherein the respective width of the turns (14, 24, 36, 48, 49, 50, 51) of one or more of said at least one other set match the respective width of one or more of said at least one notional band (35, 52).

5. A current transducer as claimed in any preceding claim, wherein said at least one corner section (32) is curved and located at a respective intersection between substantially straight sections (31), the pitch between successive turns in each of said substantially straight sections and the respective average or effective pitch in said at least one notional band (33) of said at least one corner section being substantially equal.

6. A current transducer as claimed in any preceding claim, wherein said loop has at least one angled corner section (42, 43, 44) defined by the intersection of first and second straight sections (41), said angled corner section comprising a respective set of turns (48, 49, 50, 51) extending between a respective one of said substantially straight sections and the apex of the corner section, wherein the respective turns of each set are substantially parallel with one another, and the respective width of successive adjacent turns of each set decreases in a direction from said respective straight section towards said apex, and wherein preferably each set comprises the same number of turns.

7. A current transducer as claimed in claim 6, wherein the pitch between adjacent turns (48, 49, 50, 51) of each set is substantially constant, and preferably substantially the same as the respective pitch between adjacent turns of the other set.

8. A current transducer as claimed in any one of claims 5 to 7, wherein said sets are offset with respect to one another about a notional axis that bisects said corner section and extends radially of said loop, said offset preferably being substantially equal to 50% of the pitch between adjacent turns (48, 49, 50, 51) of said sets.

9. A current transducer as claimed in claim 5, wherein said at least one curved corner section (32) comprises at least two notional bands (33) running parallel with a notional line (35) around said loop and substantially normal to each of the respective turns that it intersects, said notional bands being mutually spaced-apart in a direction substantially perpendicular with said notional line, each notional band comprising a respective set of non-parallel turns (36), each set extending at least partly but preferably fully around said at least one corner section, and wherein preferably the angular pitch between adjacent turns of each set is substantially constant.

10. A current transducer as claimed in claim 9, wherein for each notional band (33), the effective average pitch between successive turns (36) is substantially constant, where said effective average pitch is an average of the respective pitches between adjacent turns across the entire width of the respective notional band.

11. A current transducer as claimed in claim 9 or 10, wherein the width of at least some of the turns (36) in said at least one curved corner section (32) is smaller than the width of the turns in one or more adjacent straight sections (31).

12. A current transducer as claimed in any one of claims 9 to 11, wherein one or more respective turns (36) of two or more notional bands (33) are substantially aligned, said substantially aligned turns being implemented as a single turn extending across said two or more notional bands.

13. A current transducer as claimed in any one of claims 9 to 12, wherein respective ends of respective turns (36) from respective notional bands (33) that are located adjacent a boundary between said respective notional bands are electrically connected together.

14. A current transducer as claimed in any preceding claim, wherein the effective turn's density is substantially constant along said at least one coil (12, 22, 40), preferably around said loop.

## Patentansprüche

1. Stromwandler (10, 20, 30), umfassend mindestens eine leitfähige Spule (12, 22, 40), die geformt ist, um eine Vielzahl von Windungen (14, 24, 36, 48, 49, 50, 51) zu definieren, und geformt ist, um eine Schleife zu bilden, wobei die Schleife mindestens einen Eckteilabschnitt (32, 42, 43, 44) aufweist, der eine Vielzahl von nicht parallelen Windungen umfasst, **dadurch gekennzeichnet, dass** für jede Windung ein im Wesentlichen konstantes Verhältnis zwischen entsprechenden Abschnitten des Bereichs, der durch die entsprechende Windung definiert wird, und einem entsprechenden effektiven Windungsabstand an einem korrespondierenden Punkt einer entsprechenden Integrationslinie senkrecht zu dem entsprechenden Abschnitt der Windung besteht, wobei der mindestens eine Eckteilabschnitt mindestens ein gedachtes Band (33, 52) umfasst, das zu einer entsprechenden gedachten Line (35, 53) um die Schleife parallel und zu jedem der entsprechenden Abschnitte der Windungen, die es schneidet, im Wesentlichen senkrecht verläuft, und wobei die Windungen geformt und bemessen sind, sodass das Verhältnis des Querbereichs des Schnittpunkts zwischen einer entsprechenden Windung und dem mindestens einen gedachten Band zu einem entsprechenden effektiven Abstand zwischen der Windung und einer benachbarten Windung, genommen als ein Durchschnitt über die Breite des gedachten Bands an dem Schnittpunkt, im Wesentlichen konstant ist.

2. Stromwandler nach Anspruch 1, wobei in Bezug auf das oder jedes von dem mindestens einen gedachten Band (33, 52) der Durchschnittsabstand zwischen aufeinanderfolgenden Windungen (14, 24, 36, 48, 49, 50, 51) im Wesentlichen konstant ist, wobei der Durchschnittsabstand ein Durchschnitt der entsprechenden Abstände zwischen aufeinanderfolgenden benachbarten Windungen über die gesamte Breite des entsprechenden gedachten Bands ist.

3. Stromwandler nach einem der vorangehenden Ansprüche, wobei der mindestens eine Eckteilabschnitt (32, 42, 43, 44) einen ersten Satz Windungen (48, 49) mit einer kompletten Breite und mindestens einen anderen Satz Windungen (34, 51) mit einer Breite, die geringer als die komplette Breite ist, beinhaltet und wobei vorzugsweise entsprechende Sätze Windungen entlang der Länge des mindestens einen Eckteilabschnitts verschachtelt sind.

4. Stromwandler nach Anspruch 3, wobei die entsprechende Breite der Windungen (14, 24, 36, 48, 49, 50, 51) von einem oder mehreren des mindestens einen anderen Satzes mit der entsprechenden Breite von einem oder mehreren des mindestens einen gedachten Bands (35, 52) übereinstimmt.

5. Stromwandler nach einem der vorangehenden Ansprüche, wobei der mindestens eine Eckteilabschnitt (32) gebogen ist und sich an einem entsprechenden Schnittpunkt zwischen im Wesentlichen geraden Teilabschnitten (31) befindet, wobei der Abstand zwischen aufeinanderfolgenden Windungen in jedem der im Wesentlichen geraden Teilabschnitte und der entsprechende Durchschnitts- oder effektive Abstand in dem mindestens einen gedachten Band (33) des mindestens einen Eckteilabschnitts im Wesentlichen gleich sind.

6. Stromwandler nach einem der vorangehenden Ansprüche, wobei die Schleife mindestens einen gewinkelten Eckteilabschnitt (42, 43, 44) aufweist, der durch den Schnittpunkt des ersten und zweiten geraden Teilabschnitts (41) definiert wird, wobei der gewinkelte Eckteilabschnitt einen entsprechenden Satz Windungen (48, 49, 50, 51) umfasst, der sich zwischen einem entsprechenden einen der im Wesentlichen geraden Teilabschnitte und dem Scheitelpunkt des Eckteilabschnitts erstreckt, wobei die entsprechenden Windungen jedes Satzes im Wesentlichen parallel zueinander sind und die entsprechende Breite von aufeinanderfolgenden benachbarten Windungen jedes Satzes in einer Richtung von dem entsprechenden geraden Teilabschnitt zu dem Scheitelpunkt abnimmt und wobei vorzugsweise jeder Satz dieselbe Anzahl Windungen umfasst.

7. Stromwandler nach Anspruch 6, wobei der Abstand zwischen benachbarten Windungen (48, 49, 50, 51) jedes Satzes im Wesentlichen konstant ist und vorzugsweise im Wesentlichen gleich dem entsprechenden Abstand zwischen benachbarten Windungen des anderen Satzes ist.

8. Stromwandler nach einem der Ansprüche 5 bis 7, wobei die Sätze um eine gedachte Achse, die den Eckteilabschnitt halbiert und sich radial von der Schleife erstreckt, voneinander versetzt sind, wobei der Versatz vorzugsweise im Wesentlichen gleich 50 % des Abstands zwischen benachbarten Windungen (48, 49, 50, 51) der Sätze beträgt.

9. Stromwandler nach Anspruch 5, wobei der mindestens eine gebogene Eckteilabschnitt (32) mindestens zwei gedachte Bänder (33) umfasst, die zu einer gedachten Linie (35) um die Schleife parallel und zu jeder der entsprechenden Windungen, die es schneidet, im Wesentlichen senkrecht verlaufen, wobei die gedachten Bänder in einer Richtung, die zu der gedachten Linie im Wesentlichen senkrecht ist, voneinander beabstandet sind, wobei jedes gedachte Band einen entsprechenden Satz nicht paralleler Windungen (36) umfasst, wobei sich jeder Satz mindestens teilweise aber vorzugsweise vollständig um den mindestens einen Eckteilabschnitt erstreckt und wobei vorzugsweise der Winkelabstand zwischen benachbarten Windungen jedes Satzes im Wesentlichen konstant ist.

10. Stromwandler nach Anspruch 9, wobei für jedes gedachte Band (33) der effektive Durchschnittsabstand zwischen aufeinanderfolgenden Windungen (36) im Wesentlichen konstant ist, wobei der effektive Durchschnittsabstand ein Durchschnitt der entsprechenden Abstände zwischen benachbarten Windungen über die gesamte Breite des entsprechenden gedachten Bands ist.

11. Stromwandler nach Anspruch 9 oder 10, wobei die Breite mindestens mancher der Windungen (36) in dem mindestens einen gebogenen Eckteilabschnitt (32) kleiner als die Breite der Windungen in einem oder mehreren benachbarten geraden Teilabschnitten (31) ist.

12. Stromwandler nach einem der Ansprüche 9 bis 11, wobei eine oder mehrere entsprechende Windungen (36) von zwei oder mehr gedachten Bändern (33) im Wesentlichen abgestimmt sind, wobei die im Wesentlichen abgestimmten Windungen als eine einzelne Windung, die sich über die zwei oder mehr gedachten Bänder erstreckt, ausgeführt sind.

13. Stromwandler nach einem der Ansprüche 9 bis 12, wobei entsprechende Enden entsprechender Windungen (36) von entsprechenden gedachten Bändern (33), die sich neben einer Grenze zwischen den entsprechenden gedachten Bändern befinden, elektrisch miteinander verbunden sind.

14. Stromwandler nach einem der vorangehenden Ansprüche, wobei die effektive Windungsdichte entlang der mindestens einen Spule (12, 22, 40), vorzugsweise um die Schleife herum, im Wesentlichen konstant ist.

## Revendications

1. Un transducteur de courant (10, 20, 30) comprenant au moins une bobine conductrice (12, 22, 40) façonnée de façon à définir une pluralité de spires (14, 24, 36, 48, 49, 50, 51) et façonnée de façon à former une boucle, ladite boucle possédant au moins une section d'angle (32, 42, 43, 44) comprenant une pluralité de spires non parallèles, **caractérisé en ce que**, pour chaque spire, il existe un rapport sensiblement constant entre des parties respectives de la zone définie par la spire respective et un pas de spire effectif respectif au niveau d'un point correspondant d'une ligne d'intégration respective perpendiculaire à la partie respective de ladite spire, où ladite au moins une section d'angle comprend au moins une bande théorique (33, 52) disposée parallèlement à une ligne théorique respective (35, 53) autour de ladite boucle et sensiblement perpendiculaire à chacune des parties respectives desdites spires qu'elle coupe, et où lesdites spires sont façonnées et dimensionnées de sorte que le rapport de la zone transverse de l'intersection entre une spire respective et ladite au moins une bande théorique sur un pas effectif respectif entre ladite spire et une spire adjacente pris en tant que moyenne sur la largeur de ladite bande théorique au niveau de ladite intersection soit sensiblement constant.

2. Un transducteur de courant selon la Revendication 1, où, par rapport à la, ou chacune de ladite au moins une, bande théorique (33, 52), le pas moyen entre des spires successives (14, 24, 36, 48, 49, 50, 51) est sensiblement constant, où ledit pas moyen est une moyenne des pas respectifs entre des spires adjacentes successives sur la totalité de la largeur de la bande théorique respective.

3. Un transducteur de courant selon l'une quelconque des Revendications précédentes, où ladite au moins une section d'angle (32, 42, 43, 44) comprend un premier ensemble de spires (48, 49) possédant une largeur complète et au moins un autre ensemble de spires (34, 51) possédant une largeur inférieure à ladite largeur complète, et où, de préférence, des ensembles respectifs de spires sont entrelacés le long de la longueur de ladite au moins une section d'angle.

4. Un transducteur de courant selon la Revendication 3, où la largeur respective des spires (14, 24, 36, 48, 49, 50, 51) d'un ou de plusieurs dudit au moins un autre ensemble correspond à la largeur respective d'une ou de plusieurs de ladite au moins une bande théorique (35, 52).

5. Un transducteur de courant selon l'une quelconque des Revendications précédentes, où ladite au moins une section d'angle (32) est incurvée et située à une intersection respective entre des sections sensiblement rectilignes (31), le pas entre des spires successives dans chacune desdites sections sensiblement rectilignes et la moyenne respective ou le pas effectif dans ladite au moins une bande théorique (33) de ladite au moins une section d'angle étant sensiblement égaux.

6. Un transducteur de courant selon l'une quelconque des Revendications précédentes, où ladite boucle possède au moins une section d'angle inclinée (42, 43, 44) définie par l'intersection des première et deuxième sections rectilignes (41), ladite section d'angle inclinée comprenant un ensemble de spires respectif (48, 49, 50, 51) s'étendant entre une section respective desdites sections sensiblement rectilignes et le sommet de la section d'angle, où les spires respectives de chaque ensemble sont sensiblement parallèles les unes aux autres, et la largeur respective de spires adjacentes successives de chaque ensemble diminue dans une direction à partir de ladite section rectiligne respective vers ledit sommet, et où, de préférence, chaque ensemble comprend le même nombre de spires.

7. Un transducteur de courant selon la Revendication 6, où le pas entre des spires adjacentes (48, 49, 50, 51) de chaque ensemble est sensiblement constant, et de préférence sensiblement le même que le pas respectif entre des spires adjacentes de l'autre ensemble.

8. Un transducteur de courant selon l'une quelconque des Revendications 5 à 7, où lesdits ensembles sont décalés les uns par rapport aux autres autour d'un axe théorique qui coupe ladite section d'angle et s'étend radialement à partir de ladite boucle, ledit décalage étant de préférence sensiblement égal à 50% du pas entre des spires adjacentes (48, 49, 50, 51) desdits ensembles.

9. Un transducteur de courant selon la Revendication 5, où ladite au moins une section d'angle incurvée (32) comprend au moins deux bandes théoriques (33) disposées parallèlement à une ligne théorique (35) autour de ladite boucle et sensiblement perpendiculaire à chacune des spires respectives qu'elle coupe, lesdites bandes théoriques étant mutuellement espacées dans une direction sensiblement perpendiculaire à ladite ligne théorique, chaque bande théorique comprenant un ensemble respectif de spires non parallèles (36), chaque ensemble s'étendant au moins partiellement mais de préférence totalement autour de ladite au moins une section d'angle, et où, de préférence, le pas angulaire entre des spires adjacentes de chaque ensemble est sensiblement constant.

10. Un transducteur de courant selon la Revendication 9, où, pour chaque bande théorique (33), le pas moyen effectif entre des spires successives (36) est sensiblement constant, où ledit pas moyen effectif est une moyenne des pas respectifs entre des spires adjacentes sur la totalité de la largeur de la bande théorique respective.

11. Un transducteur de courant selon la Revendication 9 ou 10, où la largeur d'au moins certaines des spires (36) dans ladite au moins une section d'angle incurvée (32) est inférieure à la largeur des spires dans une ou plusieurs sections rectilignes adjacentes (31).

12. Un transducteur de courant selon l'une quelconque des Revendications 9 à 11, où une ou plusieurs spires respectives (36) de deux ou plus bandes théoriques (33) sont sensiblement alignées, lesdites spires sensiblement alignées étant mises en oeuvre sous la forme d'une spire unique s'étendant sur lesdites deux ou plus bandes théoriques.

13. Un transducteur de courant selon l'une quelconque des Revendications 9 à 12, où des extrémités respectives de spires respectives (36) provenant de bandes théoriques respectives (33) qui sont situées adjacentes à une limite entre lesdites bandes théoriques respectives sont électriquement raccordées les unes aux autres.

14. Un transducteur de courant selon l'une quelconque des Revendications précédentes, où la densité de spire effective est sensiblement constante le long de ladite au moins une bobine (12, 22, 40), de préférence autour de ladite boucle.
